# EUROPEAN PATENT APPLICATION

(11) **EP 3 682 987 A1**
(43) Date of publication of application: **22.07.2020**
(21) Application number: 19213661.2
(22) Date of filing: 04.12.2019
(51) Int. Cl.: B22F 3/105, B22F 5/10, B23P 15/00, B33Y 10/00, B33Y 40/20, B33Y 80/00, F01N 13/00, B29C 64/00, C25D 1/02, C23C 14/00, B22F 3/24

(54) **SYSTEM AND METHOD FOR FABRICATING AN OBJECT**

(30) Priority: 18.01.2019 US 201962794514 P; 19.06.2019 US 201916446578
(71) Applicant: The Boeing Company, Chicago, IL 60606-2016 (US)
(72) Inventor: HOFFMAN, Peter L., CHICAGO, IL Illinois 60606-1596 (US); ASTON, Richard W., CHICAGO, IL Illinois 60606-1596 (US)
(74) Representative: Plasseraud IP

(57) **Abstract**

A system (100) for fabricating an object includes an additive manufacturing apparatus (102) configured to build a three dimensional (3D) tool (200) by additively depositing two or more layers of material. The system (100) includes a deposition apparatus (104) configured to deposit at least one metal on the 3D tool (200) to form the object on the 3D tool (200). The system (100) includes a burnout apparatus (106) configured to heat the 3D tool (200) to remove the 3D tool (200) from the object.

## Description

### BACKGROUND

Many components manufactured for the automotive, aerospace, and other industries include relatively complex shapes. For example, components having tubes that extend along curved paths often have a relatively complex shape due to the number of tubes and/or the relative complexity of the curved paths (e.g., tortuous paths, serpentine paths, etc.). Examples of components having tubes that provide relatively complex shapes include automotive exhausts, radio frequency (RF) diffusers, and the like. The tubes of relatively complex-shaped components are often fabricated from straight tubing that is bent to define the curved paths. But, bending the tubing stretches the wall of the tubes and thereby reduces the thickness of the tubes along the bends. Reducing the wall thickness reduces the structural integrity along the bends of the tube, which may reduce the performance, cause premature failure, and/or reduce the operational life of the components. Moreover, fabricating components having relatively complex shapes may be difficult and/or time consuming, and thereby costly. For example, attaching (e.g., welding, etc.) the tubes to other structures of the component and/or attaching various segments of the tubes together may be particularly time consuming and/or require skilled workers.

A need exists for a more efficient, less time consuming, less costly, and/or more reliable process for fabricating relatively complex-shaped components.

### SUMMARY

With those needs in mind, certain embodiments of the present disclosure provide a system for fabricating an object that includes an additive manufacturing apparatus configured to build a three dimensional (3D) tool by additively depositing two or more layers of material. The system includes a deposition apparatus configured to deposit at least one metal on the 3D tool to form the object on the 3D tool. The system includes a burnout apparatus configured to heat the 3D tool to remove the 3D tool from the object.

Certain embodiments of the present disclosure provide a method for fabricating an object. The method includes using an additive manufacturing process to build a three dimensional (3D) tool by additively depositing two or more layers of material, depositing at least one metal on the 3D tool to form the object on the 3D tool, and heating the 3D tool to remove the 3D tool from the object.

Certain embodiments of the present disclosure provide a method for fabricating an object. The method includes using an additive manufacturing process to build a three dimensional (3D) tool by additively depositing two or more layers of material. The 3D tool includes an internal passage defined by an interior surface of the 3D tool. The method also includes depositing at least one metal on the interior surface of the 3D tool to form the object within the internal passage of the 3D tool, and heating the 3D tool to remove the 3D tool from the object.

### BRIEF DESCRIPTION OF THE DRAWINGS

These and other features, aspects, and advantages of the present disclosure will become better understood when the following detailed description is read with reference to the accompanying drawings in which like numerals represent like parts throughout the drawings, wherein:
Figure 1 is a schematic diagram of a system for fabricating an object according to an embodiment of the present disclosure.
Figure 2 is a partially broken-away perspective view of a three dimensional (3D) tool and an object according to an embodiment of the present disclosure.
Figure 3 is a perspective view of a 3D tool and object according to another embodiment of the present disclosure.
Figure 4 is a perspective view of a 3D tool and object according to another embodiment of the present disclosure.
Figure 5 is a cross sectional view of a 3D tool and object according to another embodiment of the present disclosure.
Figure 6 is a flow chart illustrating a method of fabricating an object according to an embodiment of the present disclosure.
Figure 7 is a perspective view illustrating various views of a component fabricated using the system shown in Figure 1 according to an embodiment of the present disclosure.
Figure 8 is a schematic perspective view of an aircraft.
Figure 9 is a block diagram of an aircraft production and service methodology.

### DETAILED DESCRIPTION

The foregoing summary, as well as the following detailed description of certain embodiments will be better understood when read in conjunction with the appended drawings. As used herein, an element or step recited in the singular and preceded by the word "a" or "an" should be understood as not necessarily excluding the plural of the elements or steps. Further, references to "one embodiment" are not intended to be interpreted as excluding the existence of additional embodiments that also incorporate the recited features. Moreover, unless explicitly stated to the contrary, embodiments "comprising" or "having" an element or a plurality of elements having a particular property can include additional elements not having that property.

While various spatial and directional terms, such as "top," "bottom," "upper," "lower," "vertical," and the like are used to describe embodiments of the present disclosure, it is understood that such terms are merely used with respect to the orientations shown in the drawings. The orientations can be inverted, rotated, or otherwise changed, such that a top side becomes a bottom side if the structure is flipped 180 degrees, becomes a left side or a right side if the structure is pivoted 90 degrees, and the like.

Certain embodiments of the present disclosure provide systems and methods that enable objects of a component to be fabricated more efficiently, using less time, and less costly. Moreover, certain embodiments of the present disclosure provide systems and methods that enable objects of a component to be fabricated with greater structural integrity and thereby increase the performance, reduce premature failure, and increase the operational life of the components.

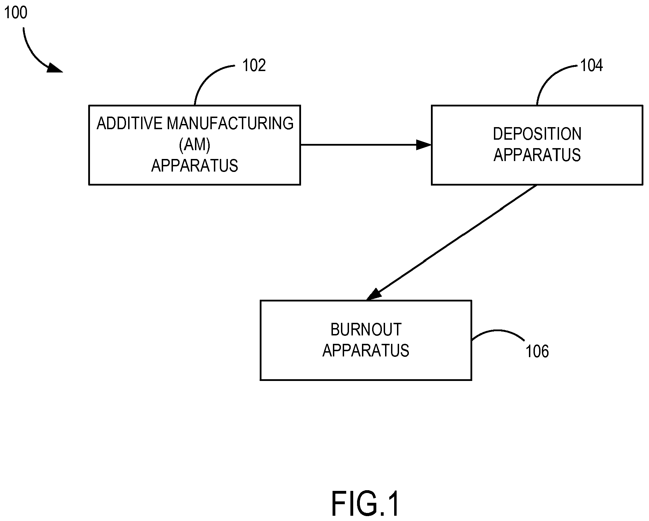

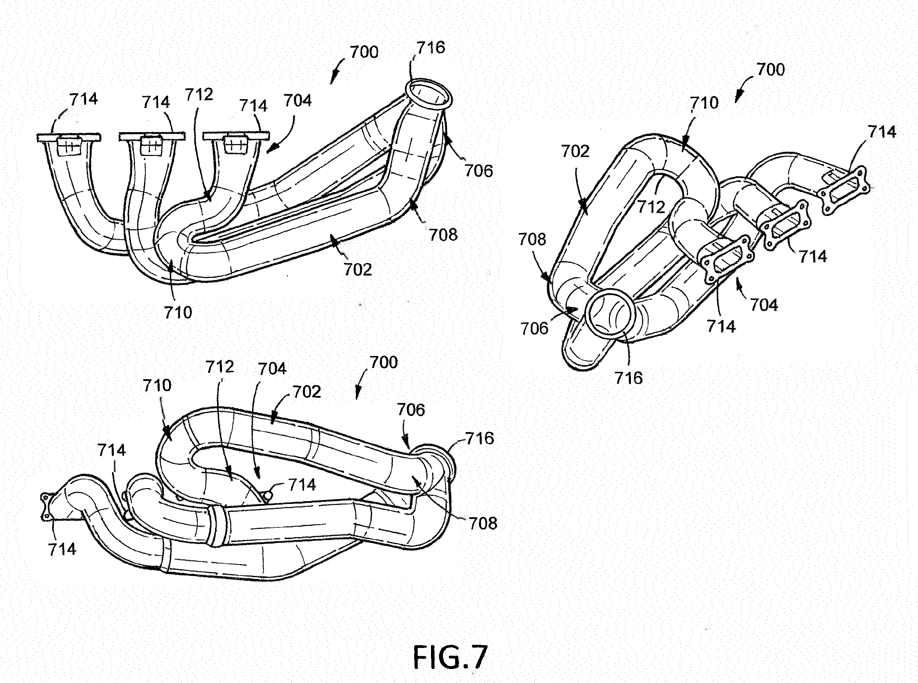

Figure 1 is a schematic diagram of a system 100 for fabricating an object of a component according to an embodiment of the present disclosure. In one implementation, the component includes one or more tubes that extend along a path that includes one or more curves (i.e., bends, etc.). The component includes a plurality of tubes that each extend along a path that includes a plurality of bends (e.g., a tortuous path, a serpentine path, etc.) in some implementations. A non-limiting example of the component fabricated by the system 100 is shown in Figure 7. Particularly, Figure 7 illustrates one implementation of an automobile exhaust 700 fabricated using the system 100. In other implementations, the system 100 is used to fabricate an automobile exhaust having other shapes, configurations, and the like than is shown in Figure 7. Another example of a component fabricated using the system is a radio frequency (RF) diffuser (not shown). The present disclosure also contemplates fabrication of any other type of component (e.g., other automotive components, other aerospace components, etc.) using the system 100 in other implementations.

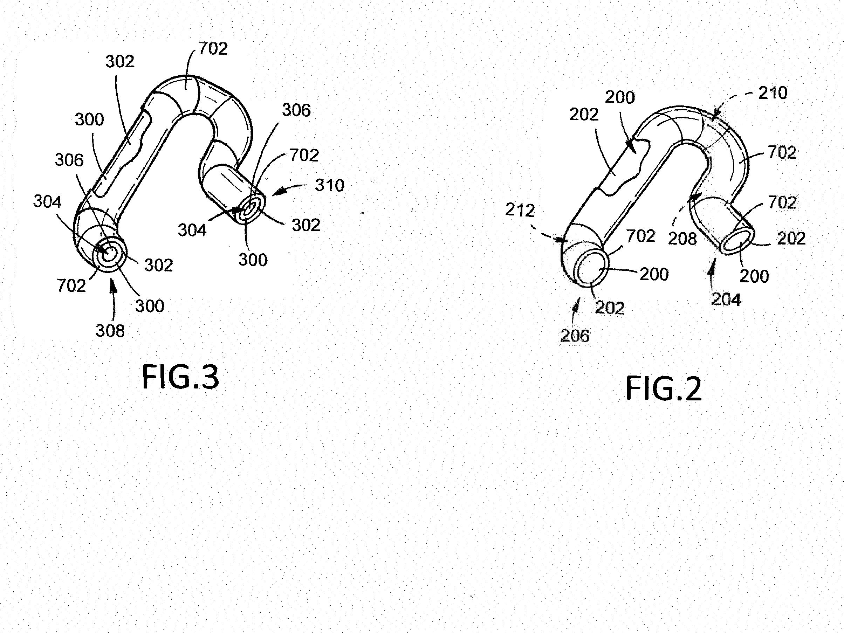

The system 100 includes an additive manufacturing (AM) apparatus 102, a deposition apparatus 104, and a burnout apparatus 106. The AM apparatus 102 is configured to additively manufacture a three dimensional (3D) tool. Specifically, the AM apparatus 102 is configured to build the 3D tool by additively depositing two or more layers of material. As will be described in more detail below, the object is fabricated by depositing one or more metals on the 3D tool and thereafter thermally removing the 3D tool from the object. Non-limiting examples of implementations of the 3D tool are shown in Figures 2-5 and described below.

Any type of AM process is used that enables the AM apparatus 102 to additively manufacture the 3D tool. In one implementation, the AM apparatus 102 is a stereolithography apparatus that is configured to build the 3D tool using a stereolithography process. In other implementations, the AM apparatus 102 is a selective laser sintering (SLS) apparatus that is configured to build the 3D tool using an SLS process, a fused filament fabrication (FFF) apparatus that is configured to build the 3D tool using an FFF process, or a selective laser melting (SLM) apparatus that is configured to build the 3D tool using an SLM process. In some implementations, the AM apparatus 102 includes one or more of the following: a powder fed laser deposition apparatus; a powder bed fusion apparatus (e.g., a powder bed apparatus, a wire feed apparatus, etc.); a metal jetting apparatus; and a directed energy deposition apparatus.

The 3D tool includes any material(s) that enables the object to be formed on the 3D tool by the deposition apparatus 104. The 3D tool includes one or more of a polymer, a thermoplastic, a polyaryletherketone (PAEK), or a carbon reinforced polymer. In some implementations, the 3D tool includes polyetherketoneketone (PEKK). In some implementations, the 3D tool incudes carbon fiber PEKK (CF-PEKK). In some implementations, the 3D tool is sufficiently electrically conductive to enable the object to be deposited on the 3D tool using an electrodeposition process.

In some implementations, the 3D tool is a mandrel that includes an exterior surface on which the object is deposited by the deposition apparatus 104 (shown in Figure 1). For example, Figure 2 illustrates one implementation of a 3D tool 200. The 3D tool 200 is a mandrel having an exterior surface 202. As can be seen from a comparison of Figures 2 and 7, the exterior surface 202 of the implementation of the 3D tool 200 has a shape that mimics the shape of an object (i.e., a primary tube 702) of the implementation of the exhaust 700 shown in Figure 7. Specifically, and referring now to Figure 7, the primary tube 702 extends a length along a curved path from an end portion 704 to an opposite end portion 706. The curved path of the primary tube 702 includes a plurality of bends 708, 710, and 712. The primary tube 702 has been broken-away in Figure 2 to better illustrate the 3D tool 200. As shown in Figure 2, the 3D tool 200 extends a length along a curved path from an end portion 204 to an opposite end portion 206. The curved path of the 3D tool 200 includes bends 208, 210, and 212 such that the path of the exterior surface 202 of the 3D tool 200 is complementary with the curved path of the primary tube 702 of the exhaust 700. Accordingly, the primary tube 702 of the exhaust 700 is formed into the shape shown in Figures 2 and 7 by depositing one or more metals on the exterior surface 202 of the 3D tool 200.

In the implementation shown in Figure 2, the 3D tool 200 is shown as being solid along the length of the 3D tool 200. But, the 3D tool is hollow along the length thereof in other implementations. For example, Figure 3 illustrates another implementation of a 3D tool 300. The primary tube 702 has been broken-away in Figure 3 to better illustrate the 3D tool 300. In the implementation of the 3D tool 300 shown in Figure 3, the 3D tool 300 is a mandrel having an exterior surface 302 on which one or more metals is deposited by the deposition apparatus 104 (shown in Figure 1) to form the object on the exterior surface 302 of the 3D tool 300. As can be seen in Figure 3, the 3D tool 300 is hollow along the length thereof such that the 3D tool 300 is a tube. Specifically, the 3D tool 300 includes an internal passage 304 that extends along the length of the 3D tool 300. The internal passage 304 is defined by an interior surface 306 of the 3D tool 300. In other implementations, the 3D tool 300 includes an internal cavity such that the 3D tool 300 is hollow but the internal cavity does not extend through one or both of the end portions 308 and 310 of the 3D tool 300.

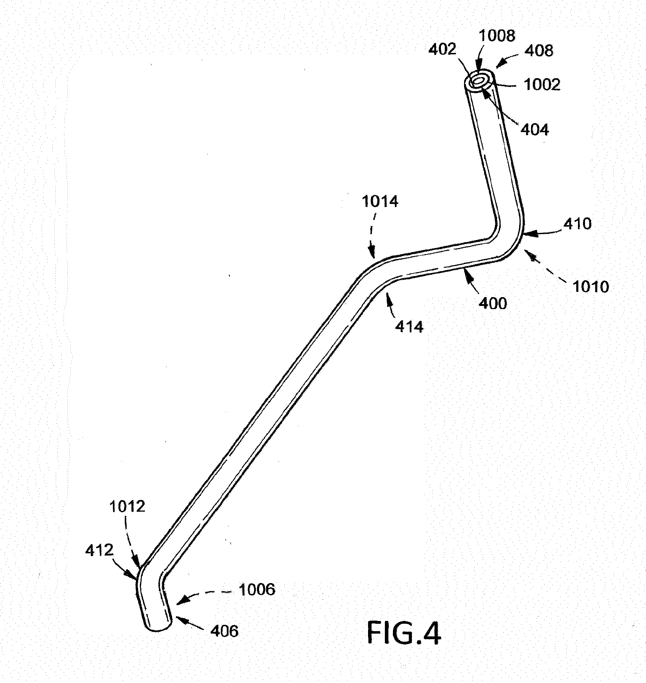

In some implementations, the 3D tool is a mold that includes an interior surface on which the object is deposited by the deposition apparatus 104 (shown in Figure 1). For example, Figure 4 illustrates one implementation of a 3D tool 400. The 3D tool 400 is a mold that is hollow along the length thereof such that the 3D tool 400 is a tube. Specifically, the 3D tool 400 has an interior surface 402 that defines an internal passage 404 that extends along the length of the 3D tool 400. As should be appreciated from Figure 4, the interior surface 402 of the implementation of the 3D tool 400 has a shape that mimics the shape of an object (i.e., a tube 1002) of an implementation of an RF diffuser. Specifically, the tube 1002 extends a length along a curved path from an end portion 1006 to an opposite end portion 1008. The curved path of the tube 1002 includes a plurality of bends 1010, 1012, and 1014. As shown in Figure 4, the 3D tool 400 extends a length along a curved path from an end portion 406 to an opposite end portion 408. The curved path of the 3D tool 400 includes bends 410, 412, and 414 such that the path of the interior surface 402 of the 3D tool 400 is complementary with the curved path of the tube 1002 of the RF diffuser. Accordingly, the tube 1002 of the RF diffuser is formed into the desired shape by depositing one or more metals on the interior surface 402 of the 3D tool 400.

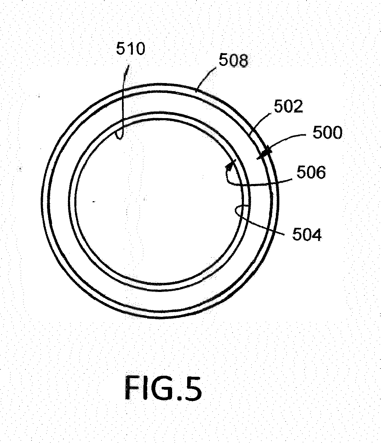

The 3D tool is both a mold and a mandrel in some implementations. For example, Figure 5 illustrates one implementation of a 3D tool 500. The 3D tool 500 is both a mandrel defined by an exterior surface 502 of the 3D tool 500 and a mold defined by an interior surface 504 of the 3D tool 500. Specifically, the interior surface 504 defines an internal passage 506 that extends along the length of the 3D tool 500. The interior surface 504 of the implementation of the 3D tool 500 has a shape (e.g., along the length and the cross section of the 3D tool 500, etc.) that mimics the shape of an object 508 being fabricated using the system 100 (shown in Figure 1). Accordingly, the object 508 is formed into the desired shape by depositing one or more metals on the interior surface 504 of the 3D tool 500. The exterior surface 502 of the implementation of the 3D tool 500 has a shape (e.g., along the length and cross section of the 3D tool 500, etc.) that mimics the shape of another object 510 being fabricated using the system 100. Accordingly, the object 510 is formed into the desired shape by depositing one or more metals on the exterior surface 502 of the 3D tool 500. The 3D tool 500 is thereby used to fabricate two objects 508 and 510 of the same component (e.g., a multi-walled tube, etc.) or objects 508 and 510 of two components.

Although the mold implementations of the 3D tools disclosed herein (e.g., the 3D tool 400, the 3D tool 500, etc.) are shown and described herein as having only a single internal passage corresponding to only a single object (e.g., the tube 1002 shown in Figure 4 of the RF diffuser, the object 508 shown in Figure 5, etc.), the mold implementations of the 3D tool contemplated by the present disclosure are not limited to the mold of a single object of a component. Rather, in some implementations wherein the 3D tool is or includes a mold, the mold is used to simultaneously fabricate multiple objects of a component, an approximate entirety of a component, and/or the like. For example, in some implementations the mold is a "negative" of a portion, a majority, an approximate entirety, and/or the like of a component (e.g., an RF diffuser, etc.) that includes a plurality of internal passages that correspond to multiple objects, tubes, structures, bases, and/or the like of the component (e.g., corresponding to a plurality of tubes of the RF diffuser and support structures that link the tubes of the RF diffuser together, etc.).

Referring again to Figure 1, the deposition apparatus 104 of the system 100 is configured to deposit at least one metal on the 3D tool to thereby form the object on the 3D tool. Any type of deposition process is used that enables the deposition apparatus 104 to form the object on the 3D tool. In some implementations, the deposition apparatus 104 is an electrodeposition apparatus, such as, but not limited to, one or more of the following: an electroplating apparatus configured to deposit one or more metals on the 3D tool using an electroplating process (e.g., electrochemical deposition, pulse electroplating, brush electroplating, electroless deposition, etc.); or an electroforming apparatus configured to deposit one or more metals on the 3D tool using an electroforming process.

In other implementations, the deposition apparatus 104 is a sputtering apparatus that is configured to deposit one or more metals on the 3D tool using a sputtering process. Any sputtering process that enables the deposition apparatus 104 to form the object on the 3D tool is used, such as, but not limited to, one or more of the following: physical sputtering, cold sputtering, electronic sputtering, potential sputtering, or chemical sputtering.

In some implementations, the particular deposition process (e.g., electrodeposition, sputtering, etc.) used to deposit the at least one metal on the 3D tool is selected based on the suitability of the particular deposition process for depositing the at least one metal on the particular type of 3D tool being used, for example based on whether the 3D tool is a mandrel (e.g., the mandrel 200 shown in Figure 2, the mandrel 300 shown in Figure 3, etc.), a mold (e.g., the mold 400 shown in Figure 4, etc.), or a combination of a mandrel and a mold (e.g., the 3D tool 500 shown in Figure 5, etc.). For example, in some implementations, sputtering processes are not suitable for depositing at least one metal on the inner surface of a mold.

In some implementations wherein the deposition apparatus 104 is an electrodeposition apparatus, the 3D tool includes an electrically conductive material (e.g., is reinforced with carbon fiber, a metal, etc.) that enables the deposition apparatus 104 to deposit one or more metals directly on the deposition surface (e.g., the exterior surface 202 shown in Figure 2, the exterior surface 302 shown in Figure 3, the interior surface 402 shown in Figure 4, the exterior surface 502 shown in Figure 5, the interior surface 504 shown in Figure 5, etc.) of the 3D tool using the electrodeposition process. Moreover, in some implementations, the deposition surface of the 3D tool is treated with one or more electrically conductive materials to enable the deposition apparatus 104 to indirectly deposit one or more metals on the 3D tool using an electrodeposition process. One example of treating the deposition surface of the 3D tool with one or more electrically conductive materials to enable electrodeposition includes coating the deposition surface with an ink (e.g., a palladium ink, etc.) and applying an electroless nickel over the ink. In some implementations, one or more of silver, gold, or copper is applied over the electroless nickel.

In some implementations of the 3D tool wherein the 3D tool is or includes a mold, one or more segments, surfaces, portions, and/or the like of the 3D tool are masked to prevent the at least one metal from being deposited on such segment(s), surface(s), portion(s), and/or the like.

Referring again to Figures 1 and 2, in some implementations, the deposition apparatus 104 is configured to form the object on the 3D tool by depositing one or more metals directly or indirectly on an exterior surface of the 3D tool. For example, Figure 2 illustrates the primary tube 702 of the exhaust 700 formed on the exterior surface 202 of the 3D tool 200. In some implementations wherein the 3D tool is a mandrel having a tube (e.g., the 3D tool 300 shown in Figure 3), the internal passage (e.g., the internal passage 304 of the 3D tool 300) of the tube of the 3D tool is covered with a cap or other cover at the end portions thereof to prevent the interior surface of the tube from being coated with the one or more metals deposited on the exterior surface by the deposition apparatus 104.

Some implementations of the system 100 includes forming the object on the 3D tool by depositing one or more metals directly or indirectly on an interior surface of the 3D tool using the deposition apparatus 104. For example, Figure 4 illustrates the tube 802 of the RF diffuser formed on the interior surface 402 of the internal passage 404 of the 3D tool 400. In still other implementations of the system 100, the deposition apparatus 104 forms two objects on the 3D tool by depositing one more metals directly or indirectly on an exterior surface and on an interior surface of the 3D tool. For example, Figure 5 illustrates an object 508 formed on the exterior surface 502 of the 3D tool 500 and another object 510 formed on the interior surface 504 of the 3D tool 500.

The object formed on the 3D tool by the deposition apparatus 104 includes any metallic material(s), such as, but not limited to, one or more of the following: stainless steel, an austenitic nickel-chromium-based superalloy; a metal matrix composite (MMC), an austenitic stainless steel alloy, an aluminum silicon alloy, an aluminum silicon magnesium alloy, an aluminum magnesium silicon alloy, an aluminum silicon magnesium manganese alloy, or Allite® super magnesium™ alloy. In one implementation, the object includes an Inconel® alloy (e.g., Inconel® 625, Inconel® 600, Inconel® X-750, Inconel® 751, Inconel® 792, Inconel® SX 300, etc.). The object includes AL 610 stainless steel in one implementation.

The deposition apparatus 104 is configured to form the object on the 3D tool with any thickness. Examples of the thickness of the object include, but are not limited to, one or more of the following: a thickness of between approximately 0.5 millimeters (mm) and approximately 2.0 mm; a thickness of less than approximately 4.0 mm; a thickness of at least approximately 0.3 mm; a thickness of greater than approximately 4.0 mm; a thickness of between approximately 0.5 mm and approximately 100 mm; or a thickness of greater than approximately 99 mm. In some implementations, the deposition apparatus 104 is configured to form the object on the 3D tool with a thickness tolerance of one or more of the following: less than approximately 8 mils; between approximately 2 mils and approximately 8 mils; less than approximately 5 mils; less than approximately 4 mils; or between approximately 1.5 mils and approximately 3.5 mils.

The burnout apparatus 106 of the system 100 is configured to heat the 3D tool to remove the 3D tool from the object. In some implementations, the burnout apparatus 106 is configured to heat the 3D tool to a temperature that combusts (i.e., burns) the 3D tool such that the 3D tool is incinerated or vaporized thereby leaving the object remaining without the 3D tool. In other implementations, the burnout apparatus 106 is configured to heat the 3D tool to a temperature that melts the 3D tool such that the 3D tool flows away from the object, thereby leaving the object remaining without the 3D tool. The burnout apparatus 106 heats the 3D tool to any suitable temperature or temperature range, which in some implementations is selected based on the material(s) of the 3D tool, the material(s) of the object, and the like. Whether the burnout apparatus 106 is configured to combust, incinerate, vaporize, or melt the 3D tool is selected to provide the object (e.g., an interior surface, an exterior surface, etc.) with a predetermined finish (e.g., smoothness, tolerance, etc.) in some implementations.

The burnout apparatus 106 is any heat source that is configured to heat the 3D tool to a temperature that removes the 3D tool from the object. Examples of the burnout apparatus 106 include, but are not limited to, one or more of the following; an oven, a torch, a kiln, or a forge. In some implementations, the material(s) of the 3D tool, the temperatures provided by the burnout apparatus 106, the type of burnout apparatus 106, and the like are selected to enable the burnout apparatus 106 to remove the 3D tool from the object without damaging the object during heating of the 3D tool by the burnout apparatus 106. Similarly, the material(s) of the object, the temperatures provided by the burnout apparatus 106, the type of burnout apparatus 106, and the like are selected to enable the object to withstand the removal of the 3D tool therefrom (e.g., withstand the temperatures provided by the burnout apparatus 106, etc.) in some implementations. The present disclosure contemplates using the burnout apparatus 106 to provide any temperatures suitable for combusting, incinerating, vaporizing, melting, and the like additively manufactured structures.

In some implementations, removal of the 3D tool from the object includes removing residue of the 3D tool from a surface (e.g., an interior surface, an exterior surface, etc.) of the object. For example, a surface of the object is wiped down, rinsed with a liquid, blown with a gas (e.g., compressed air, etc.) to remove residue of the 3D tool therefrom in some implementations.

Once the 3D tool has been removed from the object, some implementations include assembling the object with other objects and/or structures of the component to complete the component. In some implementations, assembling the object with outer objects and/or structures of the component includes one or more of the following finishing procedures to prepare the object for assembly: trimming, sanding, deburring, or filing. For example, and referring now to Figure 7, flanges 714 are attached (e.g., welded, etc.) to the end portion 704 of the primary tube 702 and the end portions of the other primary tubes of the exhaust 700. Moreover, the end portion 706 of the primary tube 702 is joined (e.g., welded, etc.) with corresponding end portions of the other primary tubes of the exhaust 700 at a flange 716 to complete the primary segment of the exhaust 700.

Although shown herein as fabricating a single object of a component, it should be understood that the system 100 is used to simultaneously fabricate two or more objects of a single component in other implementations. For example, in some implementations, the system 100 is used to build a single 3D tool that includes the shape of two or more (e.g., all four, etc.) of the primary tubes of the exhaust 700 shown in Figure 7 such that two or more of the primary tubes are simultaneously formed on the 3D tool by the deposition apparatus 104. Moreover, and for example, the system 100 is used to simultaneously form two or more of tubes (e.g., the tube 1002 shown in Figure 4, etc.) of an RF diffuser in some implementations.

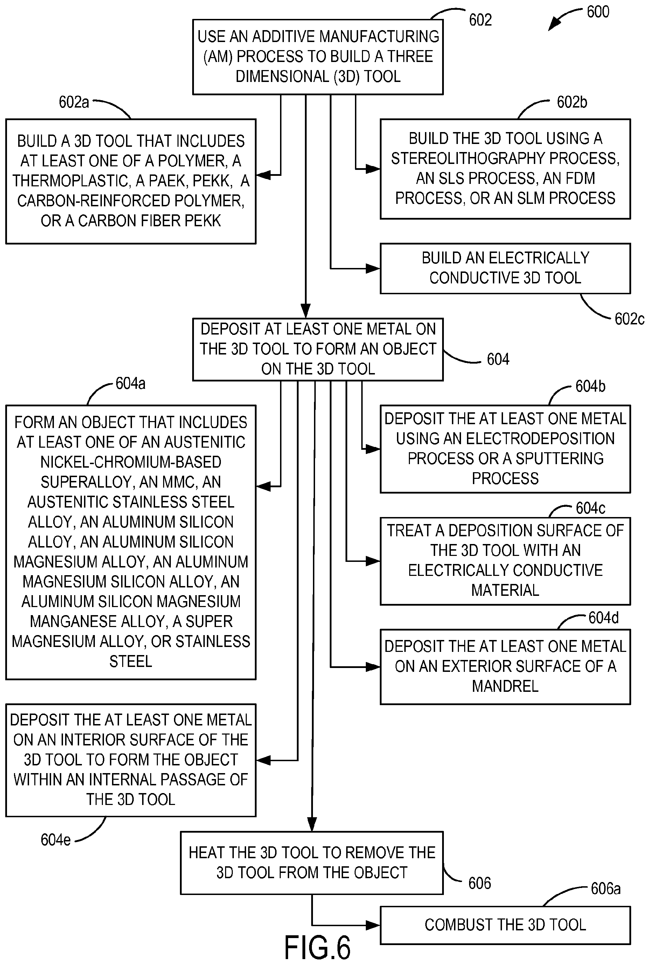

Figure 6 is a flow chart illustrating a method 600 of fabricating an object according to an embodiment of the present disclosure. The method 600 includes using, at 602, an AM process to build a 3D tool by additively depositing two or more layers of material. Using at 602 an AM process to build the 3D tool optionally includes building, at 602a, a 3D tool that includes at least one of a polymer, a thermoplastic, a PAEK, PEKK, a carbon reinforced polymer, or carbon fiber PEKK (CF-PEKK). Optionally, using at 602 an AM process to build the 3D tool includes building, at 602b, the 3D tool using a stereolithography process, an SLS process, an FFF process, or an SLM process. In some implementations, using at 602 an AM process to build the 3D tool includes building, at 602c, an electrically conductive 3D tool.

At step 604, the method 600 includes depositing at least one metal on the 3D tool to form the object on the 3D tool. In some implementations, depositing at 604 at least one metal on the 3D tool to form the object includes forming, at 604a, an object that includes at least one of an austenitic nickel-chromium-based superalloy, an MMC, an austenitic stainless steel alloy, an aluminum silicon alloy, an aluminum silicon magnesium alloy, an aluminum magnesium silicon alloy, an aluminum silicon magnesium manganese alloy, a super magnesium alloy, or stainless steel. Depositing at 604 at least one metal on the 3D tool optionally includes depositing, at 604b, the at least one metal using an electrodeposition process or a sputtering process. In some implementations, the method 600 includes treating, at 604c, a deposition surface of the 3D tool with an electrically conductive material such that the deposition surface is electrically conductive.

In some implementations, the 3D tool is a mandrel and depositing at 604 at least one metal on the 3D tool includes depositing, at 604d, the at least one metal on an exterior surface of the mandrel. Optionally, the 3D tool includes an internal passage defined by an interior surface of the 3D tool, and depositing at 604 at least one metal on the 3D tool includes depositing, at 604e, the at least one metal on the interior surface of the 3D tool to form the object within the internal passage of the 3D tool.

At step 606, the method 600 includes heating the 3D tool to remove the 3D tool from the object. In some implementations, heating at 606 the 3D tool includes combusting, at 606a, the 3D tool.

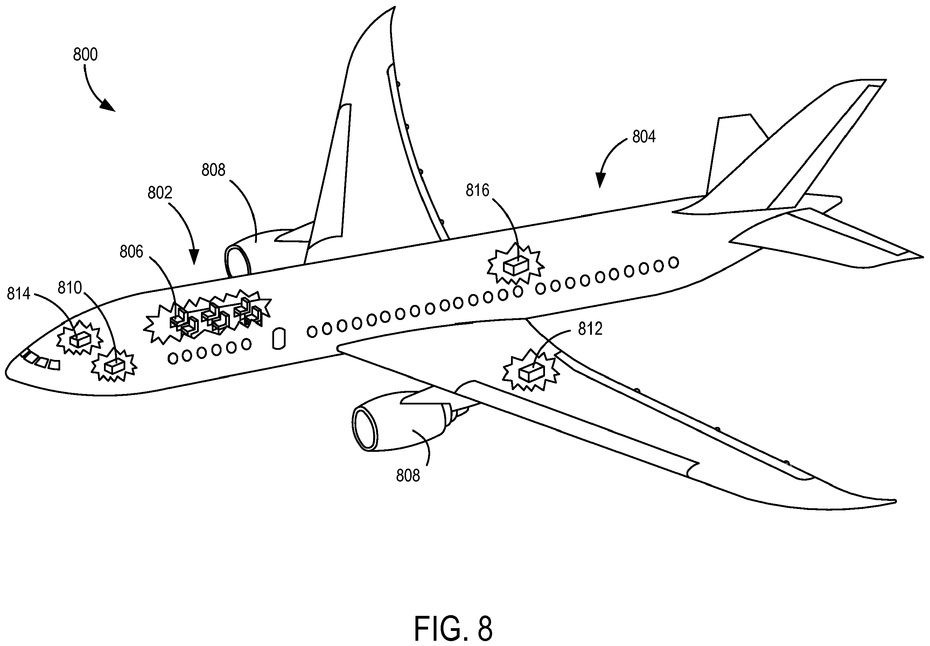

Referring now to Figure 8, examples of the disclosure may be described in the context of an aircraft 800 that can include an airframe 802 with a plurality of high-level systems 804 and an interior 806. Examples of high-level systems 804 include one or more of a propulsion system 808, an electrical system 810, a hydraulic fluid system 812, a control system 814, and an environmental system 816. Any number of other systems can be included. Although an aerospace example is shown, the principles can be applied to other industries, such as, but not limited to, the automotive industry, the marine industry, and/or the like.

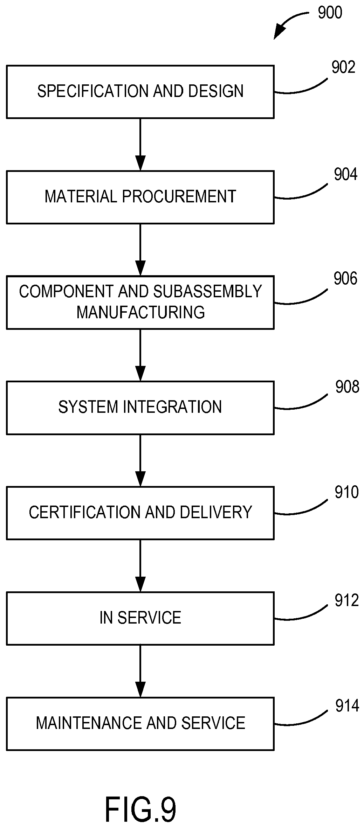

Examples of the disclosure can be described in the context of an aircraft manufacturing and service method 900 as shown in Figure 9. During pre-production, illustrative method 900 can include specification and design 902 of an aircraft (e.g., aircraft 800 shown in Figure 8) and material procurement 904. During production, component and subassembly manufacturing 906 and system integration 908 of the aircraft take place. Thereafter, the aircraft can go through certification and delivery 910 to be placed in service 912. While in service by a customer, the aircraft is scheduled for routine maintenance and service 914 (which can also include modification, reconfiguration, refurbishment, and so on).

Each of the processes of the illustrative method 900 can be performed or carried out by a system integrator, a third party, and/or an operator (e.g., a customer). For the purposes of this description, a system integrator can include, without limitation, any number of aircraft manufacturers and major-system subcontractors; a third party can include, without limitation, any number of vendors, subcontractors, and suppliers; and an operator can be an airline, leasing company, military entity, service organization, and so on.

It should be noted that any number of other systems can be included with the system described herein. Also, although an aerospace example is shown, the principles can be applied to other industries, such as the automotive industry.

Systems and methods shown or described herein can be employed during any one or more of the stages of the manufacturing and service method 900. For example, components or subassemblies corresponding to component and subassembly manufacturing 906 can be fabricated or manufactured in a manner similar to components or subassemblies produced while the aircraft is in service. Also, one or more aspects of the system, method, or combination thereof can be utilized during the production states of subassembly manufacturing 906 and system integration 908, for example, by substantially expediting assembly of or reducing the cost of the aircraft. Similarly, one or more aspects of the apparatus or method realizations, or a combination thereof, cab be utilized, for example and without limitation, while the aircraft is in service, e.g., maintenance and service 914.

Thus, various embodiments provide systems and methods that enable objects of a component to be fabricated more efficiently, using less time, and less costly. Moreover, various embodiments provide systems and methods that enable objects of a component to be fabricated with greater structural integrity and thereby increase the performance, reduce premature failure, and increase the operational life of the components.

As used herein, a structure, limitation, or element that is "configured to" perform a task or operation is particularly structurally formed, constructed, or adapted in a manner corresponding to the task or operation. For purposes of clarity and the avoidance of doubt, an object that is merely capable of being modified to perform the task or operation is not "configured to" perform the task or operation as used herein.

Any range or value given herein can be extended or altered without losing the effect sought, as will be apparent to the skilled person.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

It will be understood that the benefits and advantages described above can relate to one embodiment or can relate to several embodiments. The embodiments are not limited to those that solve any or all of the stated problems or those that have any or all of the stated benefits and advantages. It will further be understood that reference to 'an' item refers to one or more of those items.

The embodiments illustrated and described herein as well as embodiments not specifically described herein but within the scope of aspects of the claims constitute means for dual use of an hydraulic accumulator.

The term "comprising" is used in this specification to mean including the feature(s) or act(s) followed thereafter, without excluding the presence of one or more additional features or acts.

The order of execution or performance of the operations in examples of the disclosure illustrated and described herein is not essential, unless otherwise specified. That is, the operations can be performed in any order, unless otherwise specified, and examples of the disclosure can include additional or fewer operations than those disclosed herein. For example, it is contemplated that executing or performing a particular operation before, contemporaneously with, or after another operation (e.g., different steps) is within the scope of aspects of the disclosure.

When introducing elements of aspects of the disclosure or the examples thereof, the articles "a," "an," "the," and "said" are intended to mean that there are one or more of the elements. The terms "comprising," "including," and "having" are intended to be inclusive and mean that there can be additional elements other than the listed elements. The term "exemplary" is intended to mean "an example of." The phrase "one or more of the following: A, B, and C" means "at least one of A and/or at least one of B and/or at least one of C."

Having described aspects of the disclosure in detail, it will be apparent that modifications and variations are possible without departing from the scope of aspects of the disclosure as defined in the appended claims. As various changes could be made in the above constructions, products, and methods without departing from the scope of aspects of the disclosure, it is intended that all matter contained in the above description and shown in the accompanying drawings shall be interpreted as illustrative and not in a limiting sense.

It is to be understood that the above description is intended to be illustrative, and not restrictive. For example, the above-described embodiments (and/or aspects thereof) can be used in combination with each other. In addition, many modifications can be made to adapt a particular situation or material to the teachings of the various embodiments of the disclosure without departing from their scope. While the dimensions and types of materials described herein are intended to define the parameters of the various embodiments of the disclosure, the embodiments are by no means limiting and are example embodiments. Many other embodiments will be apparent to those of ordinary skill in the art upon reviewing the above description. The scope of the various embodiments of the disclosure should, therefore, be determined with reference to the appended claims, along with the full scope of equivalents to which such claims are entitled. In the appended claims, the terms "including" and "in which" are used as the plain-English equivalents of the respective terms "comprising" and "wherein." Moreover, the terms "first," "second," and "third," etc. are used merely as labels, and are not intended to impose numerical requirements on their objects. Further, the limitations of the following claims are not written in means-plus-function format and are not intended to be interpreted based on 35 U.S.C. § 112(f), unless and until such claim limitations expressly use the phrase "means for" followed by a statement of function void of further structure.

This written description uses examples to disclose the various embodiments of the disclosure, including the best mode, and also to enable any person of ordinary skill in the art to practice the various embodiments of the disclosure, including making and using any devices or systems and performing any incorporated methods. The patentable scope of the various embodiments of the disclosure is defined by the claims, and can include other examples that occur to those persons of ordinary skill in the art. Such other examples are intended to be within the scope of the claims if the examples have structural elements that do not differ from the literal language of the claims, or if the examples include equivalent structural elements with insubstantial differences from the literal language of the claims.

The following clauses describe further aspects:
Clause Set A:
   A1. A system for fabricating an object, the system comprising:
      an additive manufacturing apparatus configured to build a three dimensional (3D) tool by additively depositing two or more layers of material;
      a deposition apparatus configured to deposit at least one metal on the 3D tool to form the object on the 3D tool; and
      a burnout apparatus configured to heat the 3D tool to remove the 3D tool from the object.
   A2. The system of clause A1, wherein the 3D tool comprises at least one of a polymer, a thermoplastic, a polyaryletherketone (PAEK), polyetherketoneketone (PEKK), a carbon reinforced polymer, or carbon fiber PEKK (CF-PEKK).
   A3. The system of clause A1, wherein the object comprises at least one of an austenitic nickel-chromium-based superalloy, a metal matrix composite (MMC), an austenitic stainless steel alloy, an aluminum silicon alloy, an aluminum silicon magnesium alloy, an aluminum magnesium silicon alloy, an aluminum silicon magnesium manganese alloy, a super magnesium alloy, or stainless steel.
   A4. The system of clause A1, wherein the additive manufacturing apparatus comprises a stereolithography apparatus, a selective laser sintering apparatus, a fused filament fabrication apparatus, or a selective laser melting apparatus.
   A5. The system of clause A1, wherein deposition apparatus comprises an electrodeposition apparatus or a sputtering apparatus.
   A6. The system of clause A1, wherein the 3D tool comprises at least one of a mandrel or a mold.
   A7. The system of clause A1, wherein the 3D tool is a tube.
   A8. The system of clause A1, wherein the burnout apparatus is configured to combust the 3D tool to remove the 3D tool from the object.
   A9. The system of clause A1, wherein the object comprises a tube of an exhaust or a radio frequency (RF) diffuser.
Clause Set B:
   B1. A method for fabricating an object, the method comprising:
      using an additive manufacturing process to build a three dimensional (3D) tool by additively depositing two or more layers of material;
      depositing at least one metal on the 3D tool to form the object on the 3D tool; and
      heating the 3D tool to remove the 3D tool from the object.
   B2. The method of clause B1, wherein using an additive manufacturing process to build the 3D tool comprises building a 3D tool that comprises at least one of a polymer, a thermoplastic, a polyaryletherketone (PAEK), polyetherketoneketone (PEKK), a carbon reinforced polymer, or carbon fiber PEKK (CF-PEKK).
   B3. The method of clause B1, wherein depositing at least one metal on the 3D tool comprises forming an object that comprises at least one of an austenitic nickel-chromium-based superalloy, a metal matrix composite (MMC), an austenitic stainless steel alloy, an aluminum silicon alloy, an aluminum silicon magnesium alloy, an aluminum magnesium silicon alloy, an aluminum silicon magnesium manganese alloy, a super magnesium alloy, or stainless steel.
   B4. The method of clause B1, wherein using an additive manufacturing process to build the 3D tool comprises building the 3D tool using a stereolithography process, a selective laser sintering process, a fused filament fabrication process, or a selective laser melting process.
   B5. The method of clause B1, wherein depositing at least one metal on the 3D tool comprises depositing the at least one metal using an electrodeposition process or a sputtering process.
   B6. The method of clause B1, wherein heating the 3D tool to remove the 3D tool from the object comprises combusting the 3D tool.
   B7. The method of clause B1, further comprising treating a deposition surface of the 3D tool with an electrically conductive material such that the deposition surface is electrically conductive.
   B8. The method of clause B1, wherein the 3D tool comprises a mandrel and depositing at least one metal on the 3D tool comprises depositing the at least one metal on an exterior surface of the mandrel.
   B9. The method of clause B1, wherein the 3D tool comprises an internal passage defined by an interior surface of the 3D tool, and wherein depositing at least one metal on the 3D tool comprises depositing the at least one metal on the interior surface of the 3D tool to form the object within the internal passage of the 3D tool.
   B10. The method of clause B1, wherein using an additive manufacturing process to build the 3D tool comprises building an electrically conductive 3D tool.
Clause Set C:
   C1. A method for fabricating an object, the method comprising:
   using an additive manufacturing process to build a three dimensional (3D) tool by additively depositing two or more layers of material, wherein the 3D tool comprises an internal passage defined by an interior surface of the 3D tool;
   depositing at least one metal on the interior surface of the 3D tool to form the object within the internal passage of the 3D tool; and
   heating the 3D tool to remove the 3D tool from the object.

## Claims

1. A system (100) for fabricating an object, the system (100) comprising:
an additive manufacturing apparatus (102) configured to build a three dimensional (3D) tool (200) by additively depositing two or more layers of material;
a deposition apparatus (104) configured to deposit at least one metal on the 3D tool (200) to form the object on the 3D tool (200); and
a burnout apparatus (106) configured to heat the 3D tool (200) to remove the 3D (200) tool from the object.

2. The system (100) of claim 1, wherein the 3D tool (200) comprises at least one of a polymer, a thermoplastic, a polyaryletherketone (PAEK), polyetherketoneketone (PEKK), a carbon reinforced polymer, or carbon fiber PEKK (CF-PEKK).

3. The system (100) of claim 1, wherein the object comprises at least one of an austenitic nickel-chromium-based superalloy, a metal matrix composite (MMC), an austenitic stainless steel alloy, an aluminum silicon alloy, an aluminum silicon magnesium alloy, an aluminum magnesium silicon alloy, an aluminum silicon magnesium manganese alloy, a super magnesium alloy, or stainless steel.

4. The system (100) of claim 1, wherein the additive manufacturing apparatus (102) comprises a stereolithography apparatus, a selective laser sintering apparatus, a fused filament fabrication apparatus, or a selective laser melting apparatus.

5. The system (100) of claim 1, wherein deposition apparatus (104) comprises an electrodeposition apparatus or a sputtering apparatus.

6. The system (100) of claim 1, wherein the 3D tool (200) comprises at least one of a mandrel (300) or a mold (400).

7. The system (100) of claim 1, wherein the 3D tool (200) is a tube.

8. The system (100) of claim 1, wherein the burnout apparatus (106) is configured to combust the 3D tool (200) to remove the 3D tool (200) from the object.

9. The system (100) of claim 1, wherein the object comprises a tube (702, 1002) of an exhaust (700) or a radio frequency (RF) diffuser.

10. A method (600) for fabricating an object, the method (600) comprising:
using an additive manufacturing process to build a three dimensional (3D) tool (200) by additively depositing two or more layers of material;
depositing at least one metal on the 3D tool (200) to form the object on the 3D tool (200); and
heating the 3D tool (200) to remove the 3D tool (200) from the object.

11. The method (600) of claim 10, wherein depositing at least one metal on the 3D tool (200) comprises depositing the at least one metal using an electrodeposition process or a sputtering process.

12. The method (600) of claim 10, wherein heating the 3D tool (200) to remove the 3D tool (200) from the object comprises combusting the 3D tool (200).

13. The method (600) of claim 10, further comprising treating a deposition surface of the 3D tool (200) with an electrically conductive material such that the deposition surface is electrically conductive.

14. The method (600) of claim 10, wherein the 3D tool (200) comprises a mandrel (300) and depositing at least one metal on the 3D tool (200) comprises depositing the at least one metal on an exterior surface of the mandrel (200).

15. The method (600) of claim 10, wherein the 3D tool comprises an internal passage defined by an interior surface of the 3D tool (200), and wherein depositing at least one metal on the 3D tool (200) comprises depositing the at least one metal on the interior surface of the 3D tool (200) to form the object within the internal passage of the 3D tool (200).
